# EUROPÄISCHE PATENTSCHRIFT

(11) **EP 0 305 828 B1**
(45) Veröffentlichungstag und Bekanntmachung des Hinweises auf die Patenterteilung: **16.02.1994**
(21) Anmeldenummer: 88113540.4
(22) Anmeldetag: 20.08.1988
(51) Int. Cl.: G03F 7/022

(54) **Lichtempfindliches Gemisch auf Basis von 1,2-Naphthochinondiaziden und hiermit hergestelltes lichtempfindliches Kopiermaterial**
Light-sensitive composition based on 1,2-naphthoquinone diazides, and light-sensitive registration material made therewith
Composition photosensible à base de 1,2-naphtoquinonediazides et matériau photosensible pour l'enregistrement

(30) Priorität: 31.08.1987 DE 3729034
(43) Veröffentlichungstag der Anmeldung: 08.03.1989
(73) Patentinhaber: HOECHST AKTIENGESELLSCHAFT, 65926 Frankfurt am Main (DE)
(72) Erfinder: Stahlhofen, Paul, Dr.Dipl.-Chem., D-6200 Wiesbaden (DE)

(56) Entgegenhaltungen:
- EP-A- 0 052 788
- EP-A- 0 056 092
- EP-A- 0 193 166

## Beschreibung

Die Erfindung betrifft ein lichtempfindliches Gemisch, das im wesentlichen einen Naphthochinon-(1,2)-diazid-(2)-sulfonsäureester und ein wasserunlösliches, in wäßrig-alkalischen Lösungen lösliches oder mindestens quellbares harzartiges Bindemittel enthält. Die Erfindung betrifft auch ein hiermit hergestelltes Kopiermaterial.

Lichtempfindliche Verbindungen auf Basis von 1,2-Naphthochinondiaziden sind aus der DE-C 938 233 entsprechend GB-B 739 654, US-A 3 802 885, DE-A 31 00 077 entsprechend US-A 4 424 270 und EP-A 0 052 788 entsprechend US-A 4 407 926 bekannt. Es handelt sich hierbei um teilweise oder vollständig mit 1,2-Naphthochinondiazidsulfonsäuren veresterte Di- oder Trihydroxybenzophenone. Die Verbindungen werden vorwiegend als vollständig veresterte Vertreter verwendet, d.h. sie enthalten keine freien phenolischen Hydroxygruppen mehr. Verbindungen dieser Art haben jedoch den Nachteil einer für manche Zwecke zu geringen Lichtempfindlichkeit oder den Nachteil einer ungenügenden Löslichkeit in den üblicherweise zur Beschichtung von Schichtträgern wie Druckplatten verwendeten organischen Lösungsmitteln. Sie ergeben ferner in Kombination mit Bindemitteln wie Novolaken Schichten, die im unbelichteten Zustand gegenüber den gebräuchlichen alkalischen Entwicklerlösungen nicht genügend resistent sind. Die Schichten werden während des Druckes in Offsetdruckmaschinen bei Verwendung von Alkohol enthaltenden Feuchtwässern in gewissem Maße angegriffen wie auch von Benzinkohlenwasserstoffen, wie man sie häufig während des Druckes zum Abwaschen der oleophilen Druckfarbe von der Platte verwendet.

Aus der DE-C 11 18 606 entsprechend GB-C 935 250 sind 1,2-Naphthochinondiazidsulfonsäureester von phenolischen Verbindungen wie Derivaten des Diphenylmethans bekannt. Diese Ester enthalten aus Haftungsgründen mindestens eine freie Hydroxygruppe.

Aufgabe der Erfindung war es, ein lichtempfindliches, positiv arbeitendes Gemisch mit einem 1,2-Naphthochinon-(2)-diazidsulfonsäureester als lichtempfindliche Verbindung vorzuschlagen, das in seinen druck- und kopiertechnischen Eigenschaften mit den besten bisher bekannten Gemischen dieser Art vergleichbar ist, das aber eine höhere Chemikalienresistenz wie eine bessere Resistenz gegenüber wäßrig-alkalischen Entwicklerlösungen und den beim Offsetdruck verwendeten organischen Lösungsmitteln aufweist.

Die Lösung der Aufgabe geht von einem lichtempfindlichen Gemisch aus, das im wesentlichen als lichtempfindliche Verbindung einen Naphthochinon-(1,2)-diazid-(2)-4- oder -5-sulfonsäureester und ein wasserunlösliches, in wäßrigalkalischen Lösungen lösliches oder mindestens quellbares harzartiges Bindemittel enthält und sie ist dadurch gekennzeichnet, daß es einen Naphthochinondiazidsulfonsäureester der allgemeinen Formel I 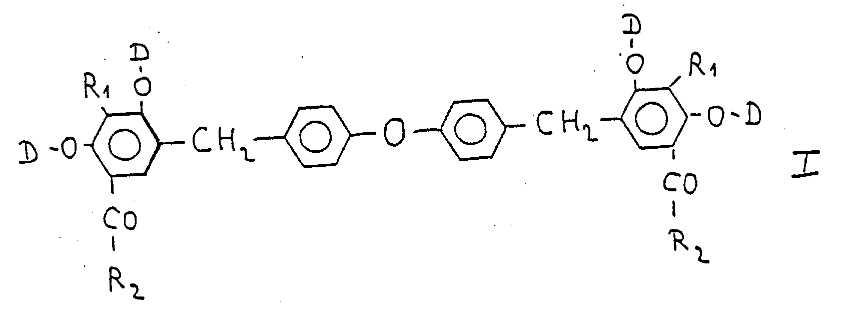
enthält, worin
- D: einen Naphthochinon-(1,2)-diazid-(2)-4-sulfonyl- oder einen Naphthochinon-(1,2)-diazid-(2)-5-sulfonylrest,
- R₁: Wasserstoff oder eine -OD-Gruppe und
- R₂: Alkyl oder gegebenenfalls substituiertes Aryl
bedeuten.

Besonders bevorzugt enthält das Gemisch einen Ester der allgemeinen Formel I, worin
- R₂: Alkyl mit 1 bis 10 Kohlenstoffatomen oder gegebenenfalls substituiertes Phenyl bedeutet.

Der Alkylrest R₂ kann geradkettig oder verzweigt sein. Der Arylrest R₂ ist vorzugsweise einkernig und kann durch Niederalkyl- oder Niederalkoxygruppen oder Halogenatome substituiert sein. Verbindungen, in denen R₂ ein Aryl-, insbesondere ein Phenylrest ist, werden bevorzugt. Dem entsprechend wird ein Naphthochinon-(1,2)-diazid-(2)-sulfonsäureester vorzugsweise verwendet, der das Veresterungsprodukt aus 1 Mol Bis-(5-benzoyl-2,3,4-trihydroxybenzyl)-4,4'-diphenylether und 6 Mol Naphthochinon-(1,2)-diazid-(2)-sulfonsäurechlorid ist.

Die in dem erfindungsgemäßen Gemisch enthaltenen 1,2-Naphthochinondiazide werden in Analogie zu bekannten Verfahren durch Veresterung der phenolischen Hydroxygruppen der Grundkörper mit 1,2-Naphthochinondiazidsulfonsäuren oder deren reaktionsfähigen Derivaten, z.B. den Sulfonsäurechloriden, hergestellt.

Die entsprechenden Grundkörper, z.B. die Bis-(2,3,4-trihydroxy-5-acylbenzyl)-4,4'-diphenylether, werden in guter Ausbeute durch Umsetzung der entsprechenden 4-Acyl-pyrogallole mit 4,4'-Bis-(methoxymethyl)-diphenylether in einem inerten Lösungsmittel, beispielsweise Diglykoldimethylether, bei 130 - 140 °C in Gegenwart von Methansulfonsäure als Kondensationsmittel erhalten.

Die erfindungsgemäßen Gemische zeichnen sich durch hohe Lichtempfindlichkeit und gute Entwicklerresistenz aus. Sie weisen ferner eine hohe Resistenz gegenüber alkoholhaltigen Feuchtwässern und gegenüber Benzinkohlenwasserstoffen aus.

Wegen ihres relativ großen Moleküls besitzt die erfindungsgemäße Verbindung eine gute Diffusionsfestigkeit. Sie eignet sich daher auch vorteilhaft für Kopierschichten, die für bestimmte Farbprüfverfahren im Mehrfarbendruck eingesetzt werden, wie zum Beispiel beim Farbprüfen nach dem sogenannten Surprint-Verfahren. Dabei stellt man ein Mehrfarbenbild dadurch her, daß Positiv-Teilfarbenbilder auf ein gemeinsames Empfangsblatt übertragen oder auf diesem erzeugt werden, ohne daß ein gesondertes Aufbringen von Zwischenschichten erforderlich ist.

Die Konzentration der erfindungsgemäßen 1,2-Naphthochinondiazidsulfonsäureester in dem lichtempfindlichen Gemisch kann in relativ weiten Grenzen schwanken. Vorzugsweise liegt der Anteil bei 3 bis 50, insbesondere bei 7 und 25 Gewichtsprozent, bezogen auf den Gehalt an nichtflüchtigen Bestandteilen des lichtempfindlichen Gemisches.

Die erfindungsgemäßen 1,2-Naphthochinondiazidsulfonsäureester können gegebenenfalls auch im Gemisch mit anderen Chinondiaziden oder mit Gemischen von Verbindungen mit mindestens einer durch Säure spaltbaren C-O-C-Bindung zusammen mit einer bei Belichtung eine starke Säure bildenen Verbindung verwendet werden.

Die erfindungsgemäßen lichtempfindlichen Gemische enthalten ferner ein polymeres, wasserunlösliches harzartiges Bindemittel, das sich in den für das erfindungsgemäße Gemisch verwendeten Lösungsmitteln löst und in wäßrigen Alkalien ebenfalls löslich oder zumindest quellbar ist.

Die bei vielen Positiv-Kopiermaterialien auf Basis von 1,2-Chinondiaziden bewährten Novolak-Kondensationsharze haben sich als Bindemittel auch hier als vorteilhaft erwiesen. Die Novolake können zusätzlich in bekannter Weise durch Umsetzung eines Teils ihrer Hydroxygruppen, z.B. mit Chloressigsäure, Isocyanaten, Epoxiden oder Carbonsäureanhydriden, modifiziert sein. Als weitere alkalilösliche bzw. in Alkali quellbare Bindemittel werden Polyhydroxyphenylharze, die durch Kondensation aus Phenolen und Aldehyden oder Ketonen hergestellt werden, Mischpolymerisate aus Styrol und Maleinsäureanhydrid, Polyvinylphenole oder Polymerisate oder Mischpolymerisate der Acrylsäure bzw. Methacrylsäure, eingesetzt. Polymerisate oder Mischpolymerisate der Acryl- und/oder Methacrylsäure, die mit Phenol, insbesondere mehrwertigem Phenol verestert sind, werden bevorzugt. Die Art und Menge des Bindemittels kann je nach Anwendungszweck verschieden sein. Bevorzugt werden Anteile am Gesamtfeststoff zwischen 90 und 39, insbesondere zwischen 85 - 55 Gewichtsprozent.

Zusätzlich können noch zahlreiche andere Harze mitverwendet werden, bevorzugt Epoxyharze und Vinylpolymerisate, wie Polyvinylacetat, Polyacrylate, Polyvinylacetale, Polyvinylether, Polyvinylpyrrolidone und die Mischpolymerisate der ihnen zugrundeliegenden Monomeren sowie hydrierte oder teilhydrierte Kolophoniumderivate. Der günstigste Anteil an diesen Harzen richtet sich nach den anwendungstechnischen Erfordernissen und nach dem Einfluß auf die Entwicklungsbedingungen und beträgt im allgemeinen nicht mehr als 50 Gewichtsprozent, bevorzugt etwa 2 bis 35 Gewichtsprozent, des eingesetzten Bindemittels. In geringen Mengen kann das lichtempfindliche Gemisch für spezielle Erfordernisse, wie Flexibilität, Haftung, Glanz und Färbung, außerdem noch Substanzen wie Polyglykole, Cellulosederivate, wie Ethylcellulose, Netzmittel, Farbstoffe, Haftvermittler und feinteilige Pigmente sowie bei Bedarf UV-Absorber enthalten.

Ferner können dem lichtempfindlichen Gemisch für den Farbumschlag nach dem Belichten noch geringe Mengen von strahlungsempfindlichen Komponenten beigefügt werden, die beim Belichten vorzugsweise starke Säuren bilden bzw. abspalten und in einer Folgereaktion mit einem geeigneten Farbstoff einen Farbumschlag hervorrufen. Derartige strahlungsempfindliche Komponenten sind zum Beispiel 1,2-Naphthochinondiazid-4-sulfonsäurechlorid, chromophor substituierte Halogenmethyl-s-triazine oder Diazoniumverbindungen in Form ihrer Salze mit komplexen Säuren wie Borfluorwasserstoffsäure oder Hexafluorphosphorsäure.

Die Erfindung betrifft auch ein lichtempfindliches Kopiermaterial aus einem Schichtträger und einer lichtempfindlichen Schicht, die das erfindungsgemäße Gemisch enthält.

Zur Beschichtung eines geeigneten Schichtträgers, wird das Gemisch im allgemeinen in einem Lösungsmittel oder Lösungsmittelgemisch gelöst. Die Wahl des Lösungsmittels ist auf das vorgesehene Beschichtungsverfahren, die Schichtdicke und die Trocknungsbedingungen abzustimmen. Geeignete Lösungsmittel sind Ketone, wie Methylethylketon, chlorierte Kohlenwasserstoffe, wie Trichlorethylen und 1,1,1-Trichlorethan, Alkohole, wie n-Propanol, Ether, wie Tetrahydrofuran, Alkoholether, wie Ethylenglykolmonoalkylether, und Ester wie Butylacetat. Lösungsmittelgemische können zudem noch für spezielle Zwecke weitere Lösungsmittel wie Acetonitril, Dioxan oder Dimethylformamid enthalten. Prinzipiell sind alle Lösungsmittel verwendbar, die mit den Schichtkomponenten nicht irreversibel reagieren. Partialether von Glykolen, insbesondere Ethylenglykolmonomethylether und Propylenglykolmethylether oder die entprechenden Monoacetate werden besonders bevorzugt.

Als Schichtträger für Schichtdicken unter ca. 10 µm werden meist Metalle verwendet. Für Offsetdruckplatten können eingesetzt werden: walzblankes, mechanisch oder elektrochemisch aufgerauhtes und gegebenenfalls anodisiertes Aluminium, das zudem noch chemisch, z.B. mit Polyvinylphosphonsäure, Silikaten, Phosphaten, Hexafluorozirkonaten oder mit hydrolisiertem Tetraethylorthosilikat, vorbehandelt sein kann.

Die Beschichtung des Schichtträgers erfolgt in bekannter Weise durch Aufschleudern, Sprühen, Tauchen, Walzen mittels Breitschlitzdüsen, Rakeln oder durch Gießer-Antrag. Belichtet wird mit den in der Technik üblichen Lichtquellen.

Zum Entwickeln werden wäßrig-alkalische Lösungen abgestufter Alkalität verwendet, vorzugsweise mit einm pH im Bereich von 10 - 14, die auch kleine Mengen organischer Lösungs- oder Netzmittel enthalten können.

Zur Herstellung einer Druckform wird das lichtempfindliche Material unter einer Positiv-Vorlage bildmäßig belichtet und anschließend mittels eines wäßrig-alkalischen Entwicklers entwickelt. Zur bildmäßigen Belichtung können die üblichen Kopiergeräte wie Röhrenlampen, Xenonimpulslampen, metall-halogeniddotierte Quecksilberdampflampen oder Kohlenbogenlampen verwendet werden.

Bevorzugte Anwendung finden die erfindungsgemäßen lichtempfindlichen Gemische bei der Herstellung von Kopiermaterialien wie Druckformen, d.h. insbesondere Offset-, autotypischen Tiefdruck- und Siebdruckformen oder in Kopierlacken und sogenannten Trockenresists.

Die unter Verwendung der erfindungsgemäßen 1,2-Naphthochinondiazide hergestellten Druckplatten besitzen eine hohe praktische Lichtempfindlichkeit sowie eine verbesserte Resistenz gegenüber alkalischen Entwicklern und solchen organischen Lösungsmitteln, wie sie üblicherweise während der Kopierarbeiten oder während des Druckvorgangs an den Druckmaschinen verwendet werden. Die erfindungsgemäßen 1,2-Naphthochinondiazide selbst zeichnen sich durch eine gute Löslichkeit in den üblichen Lösungsmitteln, durch eine starke Oleophilie sowie durch eine gute Verträglichkeit mit den übrigen Bestandteilen der Kopierschicht aus. Die Erfindung wird anhand der folgenden Beispiele näher erläutert, in denen Gewichtsteile (Gt) und Volumenteile (Vt) im Verhältnis von g zu cm³ stehen. Prozente sind, wenn nichts anderes angegeben ist, Gewichtsprozente.

### Beispiel 1:

Mit einer Lösung von
1,60 Gt des Veresterungsproduktes aus 1 Mol Bis-(5-benzoyl-2,3,4-trihydroxy-benzyl)-4,4'-diphenylether und 6 Mol Naphthochinon-(1,2)-diazid-(2)-5-sulfonsäurechlorid,
7,00 Gt eines Kresol-Formaldehyd-Novolaks mit einem Schmelzbereich von 127 - 145 °C,
0,06 Gt 2,4-Bis-(trichlormethyl)-6-p-stilbenyl-s-triazin und
0,07 Gt Kristallviolett in
40 Vt Ethylenglykolmonomethylether und
60 Vt Tetrahydrofuran
wurde eine elektrochemisch aufgerauhte und anodisierte Aluminiumplatte mit einem Oxidgewicht von 3 g/m² beschichtet. Der anodisierte Aluminiumträger war vor dem Aufbringen der lichtempfindlichen Schicht mit einer wäßrigen Lösung von Polyvinylphosphonsäure behandelt worden, wie es in der DE-C 16 21 478 entsprechend US-A 4 153 461 beschrieben ist.

Das so erhaltene lichtempfindliche Material mit einem Gewicht der lichtempfindlichen Schicht von ca. 2,3 g/m² wurde unter einer transparenten Positiv-Vorlage bildmäßig belichtet und anschließend mit einer 4 %igen wäßrigen Lösung von Natriummetasilikat entwickelt.

Durch die Entwicklung wurden die vom Licht getroffenen Anteile der Kopierschicht entfernt, und es blieben die unbelichteten Bildstellen auf dem Schichtträger zurück, so daß eine der Vorlage entsprechende Druckschablone erhalten wurde. Von der so hergestellten Druckform wurden in einer Offsetdruckmaschine etwa 150.000 einwandfreie Drucke erhalten. Die Druckschablone zeichnete sich durch eine ausgezeichnete Entwicklerresistenz und Haftung auf der Unterlage aus.

Zwecks Erhöhung der Druckauflage und Verfestigung der Druckschablone kann die so hergestellte Druckform noch einer Wärmebehandlung unterzogen werden. Zu diesem Zweck wurde die nach dem Entwickeln getrocknete Druckform in einem Einbrennofen 5 Minuten lang auf 230 °C erhitzt.

Durch das Erhitzen der Druckform trat eine Verfestigung der Druckschablone ein, und die Schicht wurde resistent gegenüber Chemikalien und damit unlöslich in organischen Lösungsmitteln, wie Aceton, Alkoholen, Dimethylformamid, Toluol oder Xylol. In einer Offsetdruckmaschine wurden etwa 400.000 einwandfreie Kopien erhalten.

Das verwendete 1,2-Naphthochinondiazid kann als Photosensibilisator auch vorteilhaft in Schichten eingesetzt werden, wie sie für Farbprüfverfahren zur Kontrolle von Farbauszugsfilmen praktische Anwendung finden. Typische Zusammensetzungen entsprechender lichtempfindlicher Beschichtungslösungen sind beispielsweise angegeben in EP-A 0 179 274 entsprechend US-A 4 659 642.

In den folgenden Beispielen werden weitere Beschichtungslösungen angegeben, bei denen ähnliche Ergebnisse wie in diesem Beispiel erhalten wurden. Wenn nicht gesondert vermerkt, entsprechen Schichtträger, Herstellung und Verarbeitung der damit erhaltenen Druckplatten den obigen Angaben.

### Beispiel 2

Beschichtungslösung:
1,60 Gt des Veresterungsproduktes aus 1 Mol Bis-(5-octanoyl-2,3,4-trihydroxy-benzyl)-4,4'-diphenylether und 6 Mol Naphthochinon-(1,2)-diazid-(2)-5-sulfonsäurechlorid,
7,00 Gt eines Kresol-Formaldehyd-Novolaks mit einem Schmelzbereich von 127 - 145 °C,
0,06 Gt 2,4-Bis-(trichlormethyl)-6-p-stilbenyl-s-triazin und
0,07 Gt Kristallviolett in
40 Vt Ethylenglykolmonomethylether,
60 Vt Tetrahydrofuran.

### Beispiel 3

1,80 Gt des Veresterungsproduktes aus 1 Mol Bis-(5-benzoyl-2,3,4-trihydroxy-benzyl)-4,4'-diphenylether und 6 Mol Naphthochinon-(1,2)-diazid-(2)-4-sulfonsäurechlorid,
7,00 Gt eines Kresol-Formaldehyd-Novolaks mit einem Schmelzbereich von 127 - 145 °C,
0,06 Gt 2,4-Bis-(trichlormethyl)-6-p-stilbenyl-s-triazin und
0,07 Gt Kristallviolett,
40 Vt Ethylenglykolmonomethylether,
60 Vt Tetrahydrofuran.

### Beispiel 4

1,80 Gt des Veresterungsproduktes aus 1 Mol Bis-(5-acetyl-2,3,4-trihydroxy-benzyl)-4,4'-diphenylether und 6 Mol Naphthochinon-(1,2)-diazid-(2)-5-sulfonsäurechlorid,
7,20 Gt eines Kresol-Formaldehyd-Novolaks mit einem Schmelzbereich von 127 - 145 °C,
0,06 Gt 2,4-Bis-(trichlormethyl)-6-p-stilbenyl-s-triazin,
0,07 Gt Kristallviolett,
40 Vt Ethylenglykolmonomethylether,
60 Vt Tetrahydrofuran.

### Beispiel 5

1,60 Gt des Veresterungsproduktes aus 1 Mol Bis-(5-benzoyl-2,4-dihydroxy-benzyl)-4,4'-diphenylether und 4 Mol Naphthochinon-(1,2)-diazid-(2)-5-sulfonsäurechlorid,
6,80 Gt eines Kresol-Formaldehyd-Novolaks mit einem Schmelzbereich von 127 - 145 °C,
0,06 Gt 2,4-Bis-(trichlormethyl)-6-p-stilbenyl-s-triazin,
0,07 Gt Kristallviolett,
40 Vt Ethylenglykolmonomethylether, 60 Vt Tetrahydrofuran.

## Patentansprüche

1. Lichtempfindliches Gemisch, das im wesentlichen einen Naphthochinon-(1,2)-diazid-(2)-4- oder -5-sulfonsäureester und ein wasserunlösliches, in wäßrig-alkalischen Lösungen lösliches oder mindestens quellbares harzartiges Bindemittel enthält, dadurch gekennzeichnet, daß es einen Naphthochinondiazidsulfonsäureester der allgemeinen Formel I 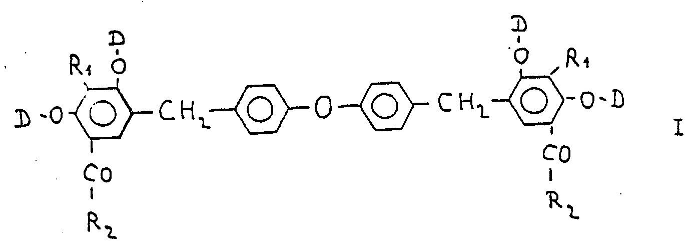 enthält, worin
D einen Naphthochinon-(1,2)-diazid-(2)-4-sulfonyl- oder einen Naphthochinon-(1,2)-diazid-(2)-5-sulfonylrest,
R₁ Wasserstoff oder eine -OD-Gruppe und
R₂ Alkyl oder gegebenenfalls substituiertes Aryl
bedeuten.

2. Gemisch nach Anspruch 1, dadurch gekennzeichnet, daß in der allgemeinen Formel I
R₂ Alkyl mit 1 bis 10 Kohlenstoffatomen oder gegebenenfalls substituiertes Phenyl bedeutet.

3. Gemisch nach Anspruch 1, dadurch gekennzeichnet, daß der Naphthochinon-(1,2)-diazid-(2)-sulfonsäureester das Veresterungsprodukt aus 1 Mol Bis-(5-benzoyl-2,3,4-trihydroxybenzyl)-4,4'-diphenylether und 6 Mol Naphthochinon-(1,2)-diazid-(2)-5-sulfonsäurechlorid ist.

4. Gemisch nach Anspruch 1, dadurch gekennzeichnet, daß es, bezogen auf seinen Gehalt an nichtflüchtigen Bestandteilen, 3 bis 50 Gewichtsprozent an Verbindungen der Formel I enthält.

5. Gemisch nach Anspruch 1, dadurch gekennzeichnet, daß das Bindemittel ein Novolak-Kondensationsharz ist.

6. Gemisch nach Anspruch 1, dadurch gekennzeichnet, daß das Bindemittel ein Polymerisat oder Mischpolymerisat ist aus Acryl- und/oder Methacrylsäure, die mit einem mehrwertigen Phenol verestert sind.

7. Lichtempfindliches Kopiermaterial aus einem Schichtträger und einer lichtempfindlichen Schicht enthaltend ein Gemisch nach Ansprüchen 1 bis 6.

## Claims

1. A light-sensitive mixture which essentially comprises a 1,2-naphthoquinone-2-diazide-4- or -5-sulfonic acid ester and a resinous binder which is insoluble in water and soluble or at least swellable in aqueous-alkaline solutions, characterized in that it comprises a naphthoquinone-diazide-sulfonic acid ester of the formula I 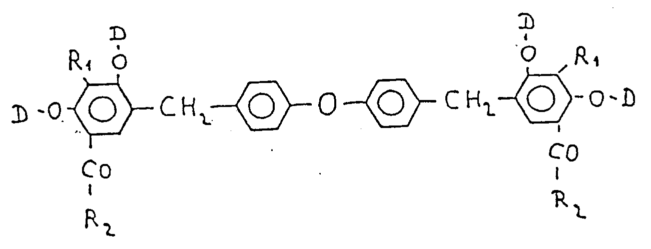 in which
D is a 1,2-naphthoquinone-2-diazide-4-sulfonyl or 1,2-naphthoquinone-2-diazide-5-sulfonyl radical,
R₁ is hydrogen or an -OD group and
R₂ is alkyl or substituted or unsubstituted aryl.

2. A mixture as claimed in claim 1, wherein, in the formula I,
R₂ is alkyl having 1 to 10 carbon atoms or substituted or unsubstituted phenyl.

3. A mixture as claimed in claim 1, wherein the 1,2-naphthoquinone-2-diazide-sulfonic acid ester is the esterification product obtained from 1 mol of 4,4'-bis-(5-benzoyl-2,3,4-trihydroxybenzyl)-diphenyl ether and 6 mol of 1,2-naphthoquinone-2-diazide-5-sulfonic acid chloride.

4. A mixture as claimed in claim 1, wherein, relative to its content of non-volatile constituents, 3 to 50 percent by weight of compounds of the formula I are contained.

5. A mixture as claimed in claim 1, wherein the binder is a novolak condensation resin.

6. A mixture as claimed in claim 1, wherein the binder is a polymer or copolymer of acrylic and/or methacrylic acid esterified with a polyhydric phenol.

7. A light-sensitive reproduction material, comprised of a support and a light-sensitive layer comprising a mixture as claimed in any of claims 1 to 6.

## Revendications

1. Mélange photosensible qui contient principalement un ester d'acide naphtoquinone-(1,2)-diazide-(2)-4- ou -5-sulfonique et un liant résineux insoluble dans l'eau et soluble ou, au moins, capable de gonfler dans des solutions aqueuses alcalines, caractérisé en ce qu'il contient un ester d'acide naphtoquinonediazidesulfonique de formule générale I 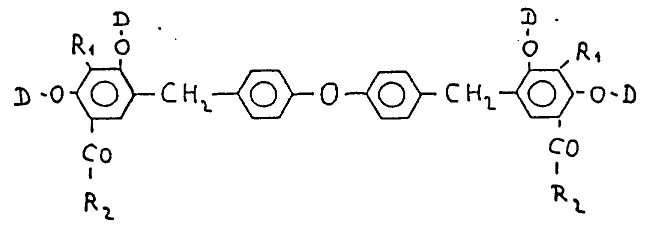 dans laquelle
D représente un radical naphtoquinone-(1,2)-diazide-(2)-4-sulfonyle ou naphtoquinone-(1,2)-diazide-(2)-5-sulfonyle,
R₁ est un atome d'hydrogène ou un groupe -OD et
R₂ est un groupe alkyle ou un groupe aryle éventuellement substitué.

2. Mélange selon la revendication 1, caractérisé en ce que, dans la formule générale I, R₂ représente un groupe alkyle ayant de 1 à 10 atomes de carbone ou un groupe phényle éventuellement substitué.

3. Mélange selon la revendication 1, caractérisé en ce que l'ester d'acide naphtoquinone-(1,2)-diazide-(2)-sulfonique est le produit d'estérification de 1 mole d'éther bis-(5-benzoyl-2,3,4-trihydroxybenzyl)-4,4'-diphénylique et de 6 moles de chlorure d'acide naphtoquinone-(1,2)-diazide-(2)-5-sulfonique.

4. Mélange selon la revendication 1, caractérisé en ce que, par rapport à sa teneur en composants non volatils, il contient de 3 à 50 pour-cent en poids de composés de formule I.

5. Mélange selon la revendication 1, caractérisé en ce que le liant est une résine novolaque de condensation.

6. Mélange selon la revendication 1, caractérisé en ce que le liant est un polymérisat ou un copolymérisat d'acide méthacrylique et/ou d'acide acrylique estérifié(s) avec un polyphénol.

7. Matériau d'enregistrement photosensible constitué d'une couche support et d'une couche photosensible contenant un mélange selon les revendications 1 à 6.
